# EUROPEAN PATENT APPLICATION

(11) **EP 2 605 277 A2**
(43) Date of publication of application: **19.06.2013**
(21) Application number: 12155174.1
(22) Date of filing: 13.02.2012
(51) Int. Cl.: H01L 23/467, H01L 23/473, F28F 13/08, F28F 1/04

(54) **Heat sink**

(30) Priority: 12.12.2011 KR 20110133190
(71) Applicant: Samsung Electro-Mechanics Co., Ltd, Suwon Gyunggi-do 443-743 (KR)
(72) Inventor: Oh, Kyu Hwan, 441-822 Gyunggi-do (KR); Hong, Chang Seob, 440-722 Gyunggi-do (KR); Kwak, Young Hoon, 443-726 Gyunggi-do (KR)
(74) Representative: Heine, Christian Klaus

(57) **Abstract**

A heat sink (100) including: a pipe (110) for refrigerant movement including a first path (110a), a third path (110c) having a cross-sectional area smaller than that of the first path (110a) in a thickness direction, and a second path (110b) connecting between the first (110a) and third paths (110c) and having a cross-sectional area in the thickness direction reduced from the first path (110a) toward the third path (110c); and a case (120) enclosing the pipe (110) for refrigerant movement.

## Description

### CROSS REFERENCE TO RELATED APPLICATION

This application claims the benefit of Korean Patent Application No. 10-2011-0133190, filed on December 12, 2011, entitled "Heat Sink", which is hereby incorporated by reference in its entirety into this application.

### BACKGROUND OF THE INVENTION

### 1. Technical Field

The present invention relates to a heat sink.

### 2. Description of the Related Art

Recently, due to an increase in energy usage and an increase in inefficiency according to miniaturization/integration, a heat radiation problem has been caused in a power module.

Since this heat radiation problem has an effect on a lifespan of a component as well as a simple temperature problem, several methods for solving the heat radiation problem have been suggested.

However, since an increase in efficiency through a complicated structure causes an increase in a production cost, a simple and high efficiency heat radiation structure needs to be designed.

In addition, a basic object of a heat sink used to increase heat radiation efficiency is to lower a temperature of a power module. In this case, it is more effective to increase heat radiation performance by lowering temperatures of partially disposed heating devices rather than lowering the overall temperature of the power module.

Meanwhile, a heat sink according to the prior art has been disclosed in Korean Patent No. 0598516.

As disclosed in the above-mentioned Patent Document, the heat sink according to the prior art is manufactured in a structure in which thin fin type pillars or pin type pillars having a predetermined diameter are arranged at predetermined intervals.

However, in the heat sink according to the prior art as described above having a structure of lowering the overall temperature of the power module, it is difficult to effectively lower temperatures of partially disposed heating devices.

### SUMMARY OF THE INVENTION

The present invention has been made in an effort to provide a heat sink capable of improving heat radiation performance of each of partially disposed heating devices.

According to a preferred embodiment of the present invention, there is provided a heat sink including: a pipe for refrigerant movement including a first path, a third path having a cross-sectional area smaller than that of the first path in a thickness direction, and a second path connecting between the first and third paths and having a cross-sectional area in the thickness direction reduced from the first path toward the third path; and a case enclosing the pipe for refrigerant movement.

The number of each of the first paths, the second paths, and the third paths may be plural.

The first and third paths may be alternately arranged.

The number of pipes for refrigerant movement may be plural, and the plurality of pipes for refrigerant movement may be arranged in the thickness direction.

A cross-sectional area of the pipe for refrigerant movement may be in proportion to a change in width of the pipe for refrigerant movement in the thickness direction.

A cross-sectional area of the pipe for refrigerant movement may be in proportion to a change in height of the pipe for refrigerant movement in the thickness direction.

Each of one surfaces and the other surfaces of the second and third paths of the pipe for refrigerant movement may contact inner side surfaces of the case, and a semiconductor chip may be attached onto the case and be attached onto the case at a region at which the case contacts the third path.

At least one of one surfaces and the other surfaces of the second and third paths of the pipe for refrigerant movement may contact inner side surfaces of the case and the other thereof may be spaced apart from the inner side surface of the case, and a semiconductor chip may be attached onto the case and be attached onto the case at a region at which the case contacts the third path.

Each of both distal ends of the case in a length direction may be provided with a refrigerant inlet through which the refrigerant is introduced to the pipe for refrigerant movement and a refrigerant outlet through which the refrigerant is discharged from the pipe for refrigerant movement.

The number of pins may be plural, the pin may have a plate shape, and the pin may be formed so that one surface and the other surface thereof are in parallel with a direction in which the refrigerant flows.

According to another preferred embodiment of the present invention, there is provided a heat sink including: a pipe for refrigerant movement including a first path, a third path having a cross-sectional area smaller than that of the first path in a thickness direction, and a second path connecting between the first and third paths and having a cross-sectional area in the thickness direction reduced from the first path toward the third path; and a case enclosing the pipe for refrigerant movement, wherein a cross-sectional area of the pipe for refrigerant movement is in proportion to changes in width and height of the pipe for refrigerant movement in the thickness direction.

The heat sink may further include a pin formed in the third path.

The number of pins may be plural, the pin may have a plate shape, and the pin may be formed so that one surface and the other surface thereof are in parallel with a direction in which the refrigerant flows.

### BRIEF DESCRIPTION OF THE DRAWINGS

FIG. 1 is a perspective view showing a structure of a heat sink according to a first preferred embodiment of the present invention;
FIG. 2 is a perspective view showing a structure of a heat sink according to a second preferred embodiment of the present invention;
FIG. 3 is a perspective view showing a structure of a heat sink according
FIG. 4 is a plan view showing the structure of the heat sink according to the first preferred embodiment of the present invention;
FIG. 5 is a side view showing the structure of the heat sink according to a second preferred embodiment of the present invention;
FIG. 6 is a view showing a change in refrigerant flow in the heat sink according to the first preferred embodiment of the present invention;
FIG. 7 is a view showing a change in refrigerant flow in the heat sink according to the second preferred embodiment of the present invention; and
FIG. 8 is a perspective view showing a structure of a heat sink according to a fourth preferred embodiment of the present invention.

### DESCRIPTION OF THE PREFERRED EMBODIMENTS

Various features and advantages of the present invention will be more obvious from the following description with reference to the accompanying drawings.

The terms and words used in the present specification and claims should not be interpreted as being limited to typical meanings or dictionary definitions, but should be interpreted as having meanings and concepts relevant to the technical scope of the present invention based on the rule according to which an inventor can appropriately define the concept of the term to describe most appropriately the best method he or she knows for carrying out the invention.

The above and other objects, features and advantages of the present invention will be more clearly understood from preferred embodiments and the following detailed description taken in conjunction with the accompanying drawings. In the specification, in adding reference numerals to components throughout the drawings, it is to be noted that like reference numerals designate like components even though components are shown in different drawings. Further, when it is determined that the detailed description of the known art related to the present invention may obscure the gist of the present invention, the detailed description thereof will be omitted. In the description, the terms "first", "second", and so on are used to distinguish one element from another element, and the elements are not defined by the above terms.

Hereinafter, preferred embodiments of the present invention will be described in detail with reference to the accompanying drawings.

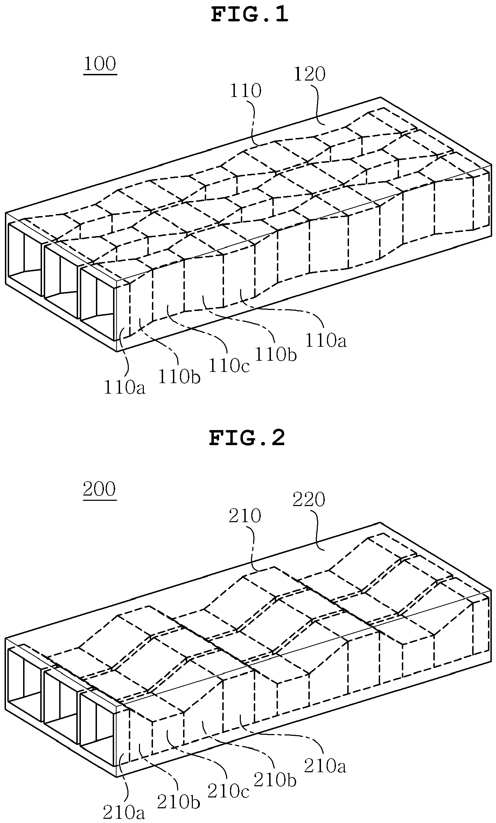

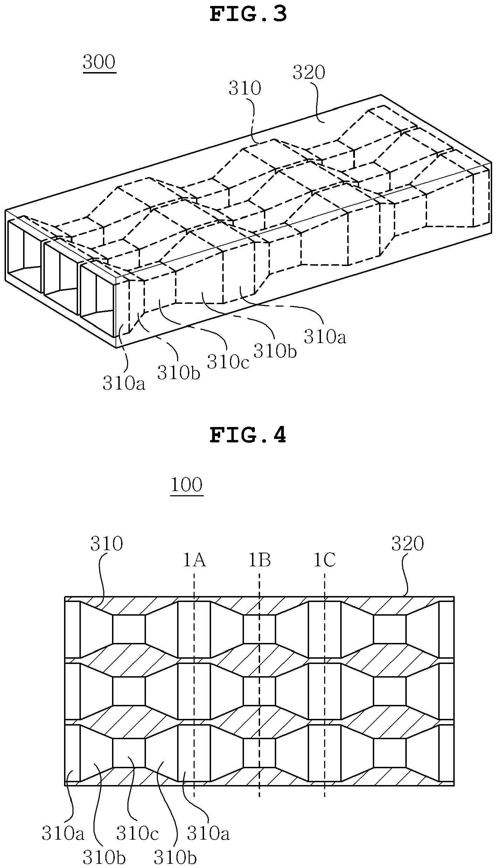

FIG. 1 is a perspective view showing a structure of a heat sink according to a first preferred embodiment of the present invention; FIG. 2 is a perspective view showing a structure of a heat sink according to a second preferred embodiment of the present invention; and FIG. 3 is a perspective view showing a structure of a heat sink according to a third preferred embodiment of the present invention.

Referring to FIGS. 1 to 3, each of the heat sinks 100, 200, and 300 according to the first to third preferred embodiments of the present invention is configured to include pipes 110, 210, and 310 for refrigerant movement and cases 120, 220, and 320 enclosing the pipes 110, 210, and 310 for refrigerant movement.

The pipes 110, 210, and 310 for refrigerant movement of the heat sinks 100, 200, and 300 according to the first to third preferred embodiments of the present invention have the following common shape.

That is, as shown in FIGS. 1 to 3, each of the pipes 110, 210, and 310 for refrigerant movement according to the respective preferred embodiments of the present invention described above includes first paths 110a, 210a, 310a, second paths 110b, 210b, and 310b, and third paths 110c, 210c, and 310c.

Here, each of the third paths 110c, 210c, and 310c may have a cross-sectional area smaller than that of the first paths 110a, 210a, and 310a in a thickness direction, and each of the second paths 110b, 210b, and 310b may connect the first paths 110a, 210a, 310a and the third paths 110c, 210c, and 310c to each other and have a cross-sectional area in the thickness direction reduced from the first paths 110a, 210a, 310a toward the third paths 110c, 210c, and 310c.

Here, the cross-sectional area in the thickness direction means a cross-sectional area of the pipes 110, 210, and 310 for refrigerant movement taken along a surface perpendicular to a direction in which the refrigerant moves.

Hereinafter, in the present specification, a thickness direction refers to a direction perpendicular to the direction in which the refrigerant moves as described above, and a length direction refers to a direction in parallel with the direction in which the refrigerant moves.

Further, in the respective preferred embodiments of the present invention, each of the first paths 110a, 210a, and 310a, the second paths 110b, 210b, and 310b, and the third paths 110c, 210c, and 310c of the pipes 110, 210, and 310 for refrigerant movement may be provided in plural, and the first paths 110a, 210a, and 310a and the third paths 110c, 210c, and 310c may be alternately arranged as shown in FIGS. 1 to 3 but is not particularly limited thereto.

As described above, the first paths 110a, 210a, and 310a and the third paths 110c, 210c, and 310c are alternately arranged to partially reduce the cross-sectional area of the pipes 110, 210, and 310 for refrigerant movement in the thickness direction, thereby making it possible to partially increase a speed of the refrigerant flowing in the pipes 110, 210, and 310 for refrigerant movement.

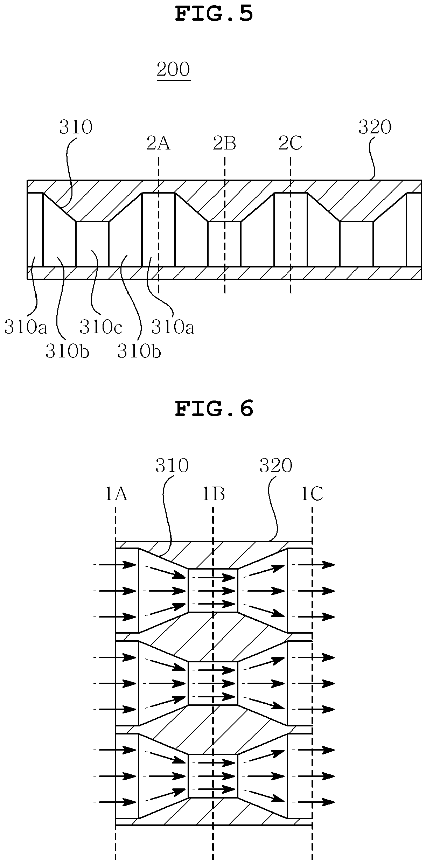

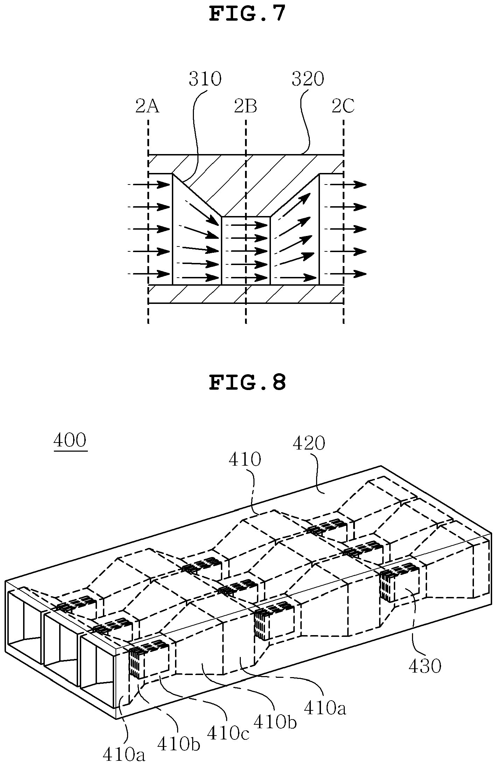

Generally, in the case in which flow amounts, that is, amounts of refrigerants flowing in the pipes 110, 210, and 310 for refrigerant movement are the same as each other, when an area through which the refrigerant passes, that is, a cross-sectional area is reduced, the refrigerant passing through a corresponding portion flows in a changed direction and at an increased speed, which is shown in FIGS. 6 and 7.

As shown in FIGS. 6 and 7, when an amount of refrigerant flowing in the first paths 110a, 210a, and 310a is the same as an amount of refrigerant flowing in the third paths 110c, 210c, and 310c, a speed of the refrigerant in the third paths 110c, 210c, and 310c having a cross-sectional area smaller than that of the first paths 110a, 210a, and 310a is much faster than that of the refrigerant in the first paths 110a, 210a, and 310a.

As described above, a flow speed of the refrigerant increases, thereby making it possible to improve heat transfer efficiency at a corresponding portion.

Further, in the respective preferred embodiments of the present invention, each of the pipes 110, 210, and 310 for refrigerant movement may be provided in plural, and the plurality of pipes 110, 210, and 310 for refrigerant movement may be arranged in parallel with each other in the thickness direction as shown in FIGS. 1 to 3, but is not particularly limited thereto.

The heat sinks 100, 200, and 300 according to the respective preferred embodiment of the present invention have the above-mentioned common shape. Hereinafter, differences among the respective preferred embodiments of the present invention will be described.

First, referring to FIG. 1, in the pipe 110 for refrigerant movement of the heat sink 100 according to the first preferred embodiment of the present invention, the third path 110c has a cross-sectional area smaller than that of the first path 110a in the thickness direction. In this case, the third path 110c may have the same height as that of the first path 110a in the thickness direction and have a width smaller than that of the first path 110a in the thickness direction.

That is, the height of the pipe 110 for refrigerant movement in the thickness direction is not changed; however, the width thereof is partially changed, for example, as shown in FIG. 4.

In the first preferred embodiment of the present invention, the cross-sectional area of the pipe 110 for refrigerant movement in the thickness direction may be changed in proportion to a change in width of the pipe 110 for refrigerant movement in the thickness direction.

In the first preferred embodiment of the present invention, each of one surfaces and the other surfaces of the first and third paths 110a to 110c of the pipe 110 for refrigerant movement may contact inner side surfaces of the case 120 as shown in FIG. 1. Then, when a semiconductor chip (not shown), which is a heating device, is attached onto the case 120, the semiconductor chip may be attached onto the case 120 at a region at which the case 120 contacts the third path 110c having the reduced cross-sectional area in the thickness direction, but is not particularly limited thereto.

Second, referring to FIG. 2, in the pipe 210 for refrigerant movement of the heat sink 200 according to the second preferred embodiment of the present invention, the third path 210c has a cross-sectional area smaller than that of the first path 210a in the thickness direction. In this case, the third path 210c may have the same width as that of the first path 210a in the thickness direction and have a height partially smaller than that of the first path 210a in the thickness direction, unlike the first preferred embodiment of the present invention described above.

That is, the width of the pipe 210 for refrigerant movement in the thickness direction is not changed; however, the height thereof is partially changed.

In the second preferred embodiment of the present invention as described above, the cross-sectional area of the pipe 210 for refrigerant movement in the thickness direction may be changed in proportion to a change in height of the pipe 210 for refrigerant movement in the thickness direction.

In the second preferred embodiment of the present invention, each of one surface and the other surface of the first path 210a of the pipe 210 for refrigerant movement may contact inner side surfaces of the case 220 as shown in FIG. 2, and at least one of one surfaces and the other surfaces of the second and third paths 210b and 210c may contact the inner side surface of the case 220 and the other thereof may be spaced apart from the inner side surface of the case 220, for example, as shown in FIG. 5.

The reason is that a semiconductor chip (not shown) is attached onto the case 220 in a subsequent process; in this case, at least one of one surface and the other surface of the pipe 210 for refrigerant movement which the semiconductor chip (not shown) is attached onto the case 220 in order to effectively radiate heat generated from the semiconductor chip.

Then, the semiconductor chip (not shown) may be attached onto the case 220 at a region at which the case 220 contacts the third path 210c having the reduced cross-sectional area in the thickness direction, but is not particularly limited thereto.

Third, referring to FIG. 3, in the pipe 310 for refrigerant movement of the heat sink 300 according to the third preferred embodiment of the present invention, the third path 310c has a cross-sectional area smaller than that of the first path 310a in the thickness direction. In this case, the third path 310c may have a width and a height smaller than those of the first path 310a in the thickness direction, unlike the first and second preferred embodiments of the present invention described above.

That is, both of the width and the height of the pipe 310 for refrigerant movement in the thickness direction are partially changed.

In the third preferred embodiment of the present invention as described above, the cross-sectional area of the pipe 310 for refrigerant movement in the thickness direction may be changed in proportion to changes in width and height of the pipe 310 for refrigerant movement in the thickness direction.

FIG. 8 shows a structure of a heat sink according to a fourth preferred embodiment of the present invention.

Referring to FIG. 8, the heat sink 400 according to the fourth preferred embodiment of the present invention 400 includes a pipe 410 for refrigerant movement, a case 420, and a plurality of pins 430.

Although a case in which a third path 410c of the pipe 410 for refrigerant movement has a width and a height partially smaller than those of a first path 410a thereof in the thickness direction, similar to a structure of the pipe 310 for refrigerant movement of the heat sink 300 according to the third preferred embodiment of the present invention described above is shown in FIG. 8, this is only an example. That is, the pipe 410 for refrigerant movement may have the same structure as those of the pipes 110 and 210 for refrigerant movement according to the first and second preferred embodiments of the present invention described above as well as the above-mentioned structure, but is not particularly limited thereto.

In the present embodiment, the plurality of pins 430 may be formed in the third path 410c of the pipe 410 for refrigerant movement. Here, the pin 430 may have a plate shape as shown in FIG. 8, but is not particularly limited thereto.

In addition, for example, the pin 430 having one surface and the other surface and also having the plate shape may be formed in the third path 410c so that one surface and the other surface thereof are in parallel with a direction in which the refrigerant flows, but is not particularly limited thereto.

As described above, in the present embodiment, the pins are additionally formed in the third path having a relatively small cross-sectional area in the thickness direction, such that a heat transfer area is increased while a refrigerant speed is increased, thereby making it possible to obtain heat transfer efficiency higher than those of the heat sinks according to the first to third preferred embodiments of the present invention described above.

As set forth above, according to the preferred embodiments of the present invention, the cross-sectional area of the pipe for refrigerant movement in the thickness direction is partially reduced to increase a refrigerant flow speed in a corresponding region, thereby making it possible to improve the heat transfer efficiency in the corresponding region.

In addition, according to the preferred embodiments of the present invention, the heating device is attached onto the case at a portion at which the case contacts a region having the reduced cross-sectional area, thereby making it possible to effectively transfer heat generated from the heating device to the refrigerant.

Although the preferred embodiments of the present invention have been disclosed for illustrative purposes, they are for specifically explaining the present invention and thus a heat sink according to the present invention is not limited thereto, but those skilled in the art will appreciate that various modifications, additions and substitutions are possible, without departing from the scope and spirit of the invention as disclosed in the accompanying claims.

Accordingly, any and all modifications, variations or equivalent arrangements should be considered to be within the scope of the invention, and the detailed scope of the invention will be disclosed by the accompanying claims.

## Claims

1. A heat sink comprising:
a pipe for refrigerant movement including a first path, a third path having a cross-sectional area smaller than that of the first path in a thickness direction, and a second path connecting between the first and third paths and having a cross-sectional area in the thickness direction reduced from the first path toward the third path; and
a case enclosing the pipe for refrigerant movement.

2. The heat sink as set forth in claim 1, wherein the number of each of the first paths, the second paths, and the third paths is plural

3. The heat sink as set forth in claim 2, wherein the first and third paths are alternately arranged.

4. The heat sink as set forth in claim 1, wherein the number of pipes for refrigerant movement is plural.

5. The heat sink as set forth in claim 4, wherein the plurality of pipes for refrigerant movement are arranged in the thickness direction.

6. The heat sink as set forth in claim 1, wherein a cross-sectional area of the pipe for refrigerant movement is in proportion to a change in width of the pipe for refrigerant movement in the thickness direction.

7. The heat sink as set forth in claim 1, wherein a cross-sectional area of the pipe for refrigerant movement is in proportion to a change in height of the pipe for refrigerant movement in the thickness direction.

8. The heat sink as set forth in claim 1, wherein each of one surfaces and the other surfaces of the second and third paths of the pipe for refrigerant movement contacts inner side surfaces of the case.

9. The heat sink as set forth in claim 8, wherein a semiconductor chip is attached onto the case and is attached onto the case at a region at which the case contacts the third path.

10. The heat sink as set forth in claim 1, wherein at least one of one surfaces and the other surfaces of the second and third paths of the pipe for refrigerant movement contacts inner side surfaces of the case and the other thereof is spaced apart from the inner side surface of the case.

11. The heat sink as set forth in claim 10, wherein a semiconductor chip is attached onto the case and is attached onto the case at a region at which the case contacts the third path.

12. The heat sink as set forth in claim 1, wherein each of both distal ends of the case in a length direction is provided with a refrigerant inlet through which the refrigerant is introduced to the pipe for refrigerant movement and a refrigerant outlet through which the refrigerant is discharged from the pipe for refrigerant movement.

13. The heat sink as set forth in claim 1, further comprising a pin formed in the third path.

14. The heat sink as set forth in claim 13, wherein the number of pins is plural.

15. The heat sink as set forth in claim 13, wherein the pin has a plate shape.

16. The heat sink as set forth in claim 15, wherein the pin is formed so that one surface and the other surface thereof are in parallel with a direction in which the refrigerant flows.

17. A heat sink comprising:
a pipe for refrigerant movement including a first path, a third path having a cross-sectional area smaller than that of the first path in a thickness direction, and a second path connecting between the first and third paths and having a cross-sectional area in the thickness direction reduced from the first path toward the third path; and
a case enclosing the pipe for refrigerant movement,
wherein a cross-sectional area of the pipe for refrigerant movement is in proportion to changes in width and height of the pipe for refrigerant movement in the thickness direction.

18. The heat sink as set forth in claim 17, further comprising a pin formed in the third path.

19. The heat sink as set forth in claim 18, wherein the number of pins is plural.

20. The heat sink as set forth in claim 18, wherein the pin has a plate shape,and
the pin is formed so that one surface and the other surface thereof are in parallel with a direction in which the refrigerant flows.
